# EUROPEAN PATENT SPECIFICATION

(11) **EP 4 476 800 B1**
(45) Date of publication and mention of the grant of the patent: **24.12.2025**
(21) Application number: 23701333.9
(22) Date of filing: 18.01.2023
(51) Int. Cl.: H01S 5/042, H01S 5/11, H01S 5/185, H01S 5/20

(54) **LASER DIODE COMPONENT**
LASERDIODENBAUELEMENT
COMPOSANT DE DIODE LASER

(30) Priority: 08.02.2022 DE 102022102877
(43) Date of publication of application: 18.12.2024
(73) Proprietor: ams-OSRAM International GmbH, 93055 Regensberg (DE)
(72) Inventor: VARGHESE, Tansen, 93047 Regensburg (DE); LUGAUER, Hans-Jürgen, 93161 Sinzing (DE); HALBRITTER, Hubert, 92345 Dietfurt (DE)
(74) Representative: Epping - Hermann - Fischer
(86) International application number: PCT/EP2023/051101
(87) International publication number: WO 2023/151908

(56) References cited:
- EP-A1- 4 131 677
- WO-A1-2021/200168
- US-B2- 10 396 528
- US-B2- 8 462 827

## Description

A laser diode component is specified. For example, the laser diode component is a PCSEL (Photonic Crystal Surface Emitting Laser).

Documents WO 2021/200168 A1, US 8,462,827 B2 and
US 10,396,528 B2 describe examples of semiconductor devices including photonic crystal structures.

PCSELs are devices that use photonic crystals inter alia to obtain vertical laser emission. One advantage is a symmetric, Gaussian beam profile. However, it is difficult to obtain high output power while maintaining high beam quality. For example, enlarging an emission aperture defined by a current injection to an emitting side may cause the Gaussian beam profile to deteriorate into a donut profile, for example, due to current crowding near a contact structure, which may be ring-shaped. This poses a problem for high power lasers if one needs a Gaussian beam profile, for example in order to couple into a fiber.

One object inter alia is to specify a high-performance laser diode component.

This object is achieved inter alia by the laser diode component according to the independent claim. Further embodiments and further developments of the laser diode component are the subject-matter of the dependent claims.

According to at least one embodiment of a laser diode component, it comprises a semiconductor layer stack including an active zone for emitting laser radiation. For example, the laser diode component is suitable for emitting laser radiation having a wavelength in the visible spectral range from ultraviolet to infrared. The laser diode component may be a high power laser diode having power outputs in the range of watts, for example between 1 W and more than 10 W. The laser diode component may be operated in pulsed mode or continuous wave mode. The laser radiation emitted from the laser diode component may have a symmetric beam profile, for example a Gaussian beam profile.

According to at least one embodiment, the laser diode component comprises a photonic crystal structure, which comprises a plurality of structured portions. A "photonic crystal structure" is a structure with a periodically changing refractive index in which a photonic band structure is formed that has regions of forbidden energy in which electromagnetic waves cannot propagate. The structured portions may be provided to cause a periodic change of the refractive index in the photonic crystal structure. For example, the structured portions may be regularly arranged in the photonic crystal structure and may form a two-dimensional lattice structure. The structured portions can have spacings in the range of one wavelength of the laser radiation and thus be in the range of fractions of a micrometer, wherein the wavelength is the wavelength in the medium, for example in the photonic crystal structure, and thus can be calculated from an average refractive index of the photonic crystal structure. Moreover, the structured portions can have dimensions of up to about half the wavelength of the laser radiation. "In the range of" or "about" means, for example, a maximum deviation of 10% from the calculated value.

According to at least one embodiment, the laser diode component comprises contacts for electrically contacting the laser diode component, wherein one contact comprises a plurality of contact portions arranged in recesses of the semiconductor layer stack and penetrating the active zone. For example, the contact portions extend from a side of the laser diode component different from an emission side, for example opposite to the emission side, through the active zone in the direction towards the emission side.

According to at least one embodiment of a laser diode component, it comprises:
- a semiconductor layer stack comprising an active zone for emitting laser radiation,
- a photonic crystal structure comprising a plurality of structured portions,
- contacts for electrically contacting the laser diode component, one contact comprising a plurality of contact portions arranged in recesses of the semiconductor layer stack,
wherein the contact portions penetrate the active zone.

According to at least one embodiment or configuration, the semiconductor layer stack comprises a first semiconductor region of a first conductivity type, for example a p-doped semiconductor region, and a second semiconductor region of a second conductivity type, for example an n-doped semiconductor region. For example, the second semiconductor region is an emission side region of the semiconductor layer stack.

The active zone may be arranged between the first and second semiconductor regions. The active zone may comprise a sequence of single layers which form a quantum well structure, in particular a single quantum well structure (SQW) or multiple quantum well structure (MQW).

Moreover, the first and second semiconductor regions may each have a sequence of single layers, some of which may be undoped or lightly doped.

The single layers of the semiconductor regions may be epitaxially deposited on a growth substrate.

The semiconductor layer stack may comprise a first cladding layer arranged in the first semiconductor region and a second cladding layer arranged in the second semiconductor region, wherein the active region is arranged between the cladding layers.

Materials based on arsenide, phosphide or nitride compound semiconductors, for example, are suitable for the semiconductor regions or single layers of the semiconductor layer stack. "Based on arsenide, phosphide or nitride compound semiconductors" means in the present context that the semiconductor layers contain AlₙGaₘIn₁₋ₙ₋ₘAs, AlₙGaₘIn₁₋ₙ₋ₘP, InₙGa₁₋ₙAsₘP₁₋ₘ or AlₙGaₘIn₁₋ₙ₋ₘN, where 0 ≤ n ≤ 1, 0 ≤ m ≤ 1 and n+m ≤ 1. This material does not necessarily have to have a mathematically exact composition according to the above formula. Rather, it may have one or more dopants as well as additional constituents that do not substantially change the characteristic physical properties of the AlₙGaₘIn₁₋ₙ₋ₘAs, AlₙGaₘIn₁₋ₙ₋ₘP, InₙGa₁₋ₙAsₘP₁₋ₘ or AlₙGaₘIn₁₋ₙ₋ₘN material. For simplicity, however, the above formula includes only the essential constituents of the crystal lattice (Al, Ga, In, As or P or N, respectively), even though these may be partially replaced by small amounts of other substances. A quinternary semiconductor consisting of Al, Ga, In (group III) and P and As (group V) is also conceivable.

According to at least one embodiment or configuration, the photonic crystal structure comprises a base layer. For example, the base layer comprises a crystal material. A "crystal material" designates a material whose constituents are predominantly arranged in a crystal structure. The photonic crystal structure can be a part of the semiconductor layer stack. And the crystal material may be a semiconductor material as mentioned above in connection with the semiconductor regions of the semiconductor layer stack. The structured portions are, for example, voids in the base layer. In particular, a medium in the structured portions or voids has a refractive index which differs from the refractive index of the base layer.

According to at least one embodiment or configuration, the laser diode component is a PCSEL. In the PCSEL, propagating waves couple with the photonic crystal structure to form standing wave modes, where nodes occur at multiples of half a wavelength of the laser radiation. As mentioned above, a lattice period of the photonic crystal structure or a spacing between the structured portions may correspond to the wavelength of the laser radiation. So, part of the nodes can occur where the structured portions are.

The photonic crystal structure may diffract the laser radiation in a vertical direction, which may be parallel to a surface-normal of a radiation outcoupling surface of the laser diode component arranged at the emission side.

The photonic crystal structure may extend in a horizontal plane arranged perpendicular to the vertical direction. According to at least one embodiment or configuration, the contact portions or recesses are regularly arranged in the semiconductor layer stack and may form a two-dimensional lattice. The plurality of regularly arranged contact portions enable a homogeneous current injection and thus an improved beam profile even if the emission aperture is enlarged, and thus a high-performance laser diode component can be realized.

According to at least one embodiment or configuration, the penetrating contact portions comprise a transparent, electrically conductive material. For example, the transparent, electrically conductive material is a transparent conductive oxide (TCO). TCOs comprise metal oxides such as zinc oxide, tin oxide, cadmium oxide, titanium oxide, indium oxide or indium tin oxide (ITO). In addition to binary metal oxygen compounds, such as ZnO, SnO₂ or In₂O₃, ternary metal oxygen compounds, such as Zn₂SnO₄, CdSnO₃, ZnSnO₃, MgIn₂O₄, GaInO₃, Zn₂In₂O₅ or In₄Sn₃O₁₂, or mixtures of different transparent conductive oxides also belong to the group of TCOs. Furthermore, the TCOs do not necessarily correspond to a stoichiometric composition and can also be p- or n-doped.

Additionally, the penetrating contact portions may comprise a reflective, electrically conductive material. The reflective, electrically conductive material may comprise or consist of a metal or metal compound. Suitable materials are Ag or Au, for example.

According to at least one embodiment or configuration, the laser diode component comprises an insulating layer laterally surrounding the contact portions in the recesses. The insulating layer may prevent the contact portions from causing leakage current along sidewalls of the recess. The insulating layer may comprise a transparent, electrically insulating material. Suitable materials for the insulating layer are, for example, silicon oxides, for example SiO₂, or silicon nitrides.

According to at least one embodiment or configuration, the photonic crystal structure is arranged outside the active zone. For example, the photonic crystal structure may be arranged on a side of the active zone facing the emission side of the laser diode component. However, it is also possible for the photonic crystal structure to be arranged on a side of the active zone facing away from the emission side of the laser diode component. Especially, the photonic crystal structure is arranged near the active zone between the cladding layers.

According to at least one embodiment or configuration, if the photonic crystal structure is arranged outside the active zone, the recesses of the semiconductor layer stack or contact portions may have greater lateral dimensions and/or spacings than the structured portions. The lateral dimensions may be determined parallel to the horizontal plane of the photonic crystal structure. The lateral dimensions and/or spacings may be greater than the wavelength of the laser radiation. However, it is also possible for the recesses or contact portions to have the same lateral dimensions and/or spacings as the structured portions.

Choosing a transparent, electrically conductive material for the contact portions as mentioned above allows the optical modes to be transmitted through the contact portions or recesses. Moreover, choosing a reflective, electrically conductive material for the contact portions as mentioned above allows the optical modes to be effectively reflected at sidewalls of the recesses. A high transparency or reflectivity is especially advantageous if the lateral dimensions and/or spacings of the contact portions are greater than the wavelength of the laser radiation.

According to at least one embodiment or configuration, the photonic crystal structure is a part of the semiconductor layer stack. Especially, the recesses where the contact portions are arranged form structured portions of the photonic crystal structure. In this embodiment or configuration, an overlap with the wave is higher than in the case where the photonic crystal structure is arranged outside the active zone. This allows a reduced refractive index contrast while still achieving the desired overall effect.

For example, the contact portions or recesses may be arranged where nodes occur. As mentioned for the structured portions, the recesses or contact portions can have spacings in the range of one wavelength of the laser radiation and thus be in the range of fractions of a micrometer. Moreover, the recesses or contact portions can have dimensions of up to about half the wavelength of the laser radiation.

According to at least one embodiment or configuration, the contact portions, for example as part of the photonic crystal structure, may have different dimensions and/or shapes and/or be arranged in different patterns or different multiple lattices of different periodicity. For example, there can be recesses of two different shapes on two different lattices.

According to at least one embodiment or configuration, the contacts comprise first contacts for electrically contacting the first semiconductor region of the semiconductor layer stack and comprise second contacts for electrically contacting the second semiconductor region of the semiconductor layer stack. The penetrating contact portions may be parts of the second contact.

According to at least one embodiment or configuration, the radiation outcoupling surface arranged at the emission side of the laser diode component, where an essential part of the laser radiation is emitted, is free of contacts. Instead, the contact portions allow for current injection to the emission side region of the semiconductor layer stack from a side different from the emission side, for example from a side opposite to the emission side. Thus, radiation losses at the radiation outcoupling surface due to radiation absorption at the contacts can be reduced.

For example, the first contact comprises a first contact pad arranged at a rear side of the laser diode component and the second contact comprises a second contact pad arranged at the rear side of the laser diode component, wherein the rear side is arranged opposite to the emission side. Alternatively, the first contact pad may be arranged at a lateral side of the laser diode component.

According to at least one embodiment or configuration, the laser diode component comprises a reflection layer facing the rear side of the laser diode component. The reflection layer may comprise alternately arranged sublayers of a higher and a lower refractive index. For example, the reflection layer is a Bragg mirror. The reflection layer helps reflect radiation which impinges on the rear side towards the emission side.

The laser diode component is suitable for display applications, for example head-up displays, for AR (augmented reality) applications, for material processing applications, for LIDAR (Light Detection And Ranging, also Light Imaging, Detection And Ranging) systems and for use in hard drives, Blu-ray or optical data transmission.

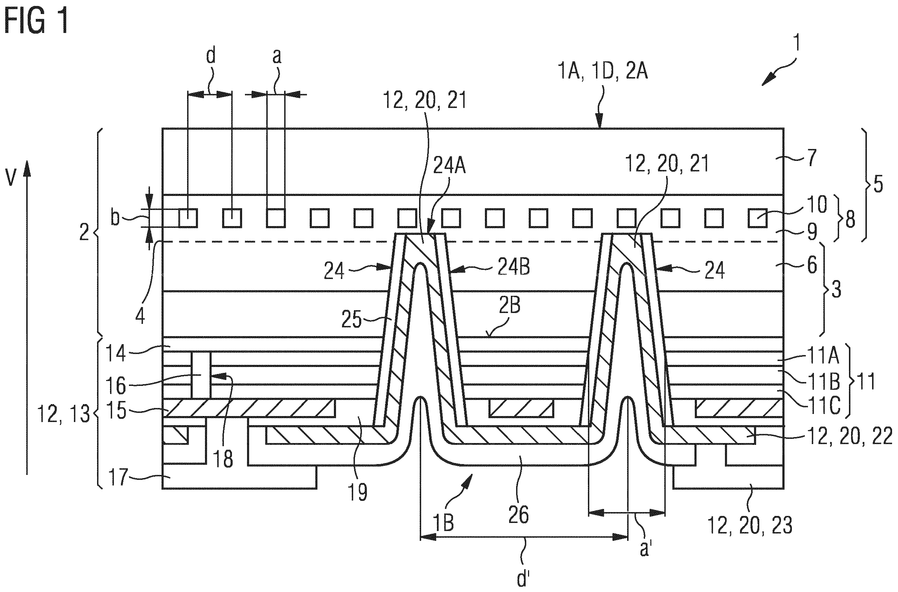

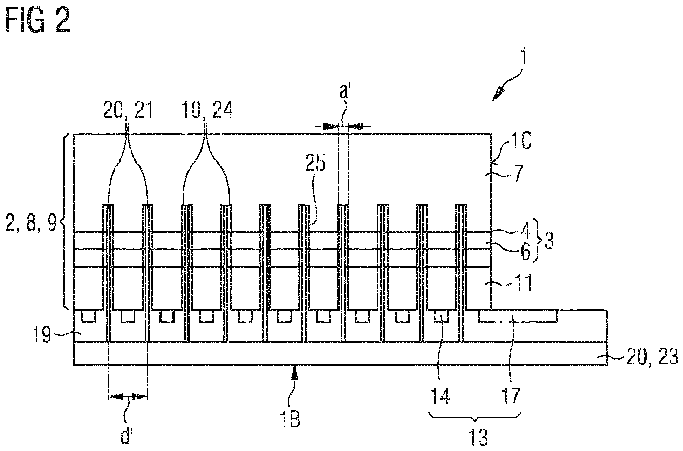

Further preferred embodiments and further developments of the laser diode component will become apparent from the exemplary embodiments explained below in conjunction with Figures 1 and 2.

Figures 1 and 2 show schematic cross-sectional views of exemplary embodiments of laser diode components.

Identical, equivalent or equivalently acting elements may be indicated with the same reference numerals in the figures. The figures are schematic illustrations and thus not necessarily true to scale. Comparatively small elements and particularly layer thicknesses can rather be illustrated exaggeratedly large for the purpose of better clarification.

An exemplary embodiment of a laser diode component 1 is described in connection with Figure 1. In particular, the laser diode component 1 is a PCSEL.

The laser diode component 1 comprises a semiconductor layer stack 2. The semiconductor layer stack 2 is, for example, a thin film semiconductor body where a growth substrate has been thinned or removed after growing, especially epitaxially growing, the semiconductor layer stack 2 on the growth substrate.

The semiconductor layer stack 2 comprises a first semiconductor region 3 of a first conductivity type, for example a p-doped semiconductor region, and a second semiconductor region 5 of a second conductivity type, for example an n-doped semiconductor region, arranged on the first semiconductor region 3 in a vertical direction V. The vertical direction V may be opposite to a growth direction of the semiconductor layer stack 2. The first and second semiconductor regions 3, 5 may each have a sequence of single layers, some of which may be undoped or lightly doped.

The semiconductor layer stack 2 further comprises an active zone 4 arranged between the first and second semiconductor regions 3, 5. During operation, the active zone 4 emits laser radiation having a wavelength, for example, in the visible spectral range from ultraviolet to infrared.

The active zone 4 may comprise a sequence of single layers which form a quantum well structure, in particular a single quantum well structure (SQW) or multiple quantum well structure (MQW). It can also be a bulk layer or layers, such as a double heterostructure.

Moreover, the first semiconductor region 3 comprises a first cladding layer 6 and the second semiconductor region 5 comprises a second cladding layer 7, wherein the active region 4 is arranged between the cladding layers 6, 7.

As mentioned above, materials based on arsenide, phosphide or nitride compound semiconductors, for example, are suitable for the semiconductor regions 3, 4, 5 or single layers of the semiconductor layer stack 2.

The laser diode component 1 further comprises a photonic crystal structure 8 arranged outside the active zone 4 between the active zone 4 and the second cladding layer 7. The photonic crystal structure 8 comprises a base layer 9 and structured portions 10. The structured portions 10 are produced, for example, by patterning the base layer 9, which originally may be a layer of uniform thickness, in a predetermined way. The structured portions 10 are, for example, voids in the base layer 9.

The photonic crystal structure 8 is a part of the semiconductor layer stack 2. And the base layer 9 comprises a semiconductor material as mentioned above in connection with the semiconductor regions 3, 4, 5. Alternatively, the photonic crystal structure 8 may be a separate element with a base layer 9 formed from a material different from the semiconductor layer stack 2. However, the base layer 9 may be a crystal layer anyway. The structured portions 10 or voids are filled with a medium, for example air or SiO₂, having a refractive index which differs from the refractive index of the material of the base layer 9.

The structured portions 10 are regularly arranged in the photonic crystal structure 8 and form a two-dimensional lattice structure. The structured portions 10 have spacings d in the range of one wavelength of the laser radiation and thus are in the range of fractions of a micrometer, wherein the wavelength is the wavelength in the medium or in the photonic crystal structure 8 and thus can be calculated from an average refractive index of the photonic crystal structure 8. Moreover, the structured portions 10 have dimensions including lateral dimensions a as well as vertical dimensions b of up to about half the wavelength of the laser radiation, wherein the lateral dimensions a are determined parallel to a horizontal plane of the photonic crystal structure 8 and the vertical dimensions b are determined parallel to the vertical direction V.

The structured portions 10 are provided to cause a periodic change of the refractive index in the photonic crystal structure 8.

The photonic crystal structure 8 serves as part of a lasing cavity. In addition, the photonic crystal structure 8 can diffract the radiation in the vertical direction V, which allows the component 1 to function as a surface-emitting laser diode component.

The laser diode component 1 comprises a radiation outcoupling surface 1D arranged at an emission side 1A of the laser diode component 1, where an essential part of the laser radiation is emitted. A surface-normal of the radiation outcoupling surface 1D may be parallel to the vertical direction V. The radiation outcoupling surface 1D may be a first main surface 2A of the semiconductor layer stack 2.

Moreover, on a rear side 1B opposite to the emission side 1A, the laser diode component 1 comprises a reflection layer 11 arranged on a second main surface 2B of the semiconductor layer stack 2, wherein the second main surface 2B is arranged opposite to the first main surface 2A. The reflection layer 11 comprises alternately arranged sublayers 11A, 11B of higher and lower refractive indices. Suitable materials for the sublayers 11A, 11B are dielectric materials like titanium oxide and silicon dioxide. Especially, the reflection layer 11 is a Bragg mirror. The reflection layer 11 helps reflect radiation which impinges on the rear side 1B towards the emission side 1A.

The laser diode component 1 further comprises contacts 12 for electrically contacting the laser diode component 1 from the rear side 1B. As a consequence, it is possible that the radiation outcoupling surface 1D is free of contacts 12. Thus, radiation losses at the radiation outcoupling surface 1D due to radiation absorption at the contacts can be reduced.

The contacts 12 comprise a first contact 13 for electrically contacting the first semiconductor region 3 of the semiconductor layer stack 2 and further comprise a second contact 20 for electrically contacting the second semiconductor region 5 of the semiconductor layer stack 2.

The first contact 13 comprises a first contact layer 14 arranged on the second main surface 2B between the first semiconductor region 3 and the reflection layer 11. The first contact layer 14 electrically contacts the first semiconductor region 3 and comprises an electrically conductive material, for example a metal material.

The first contact 13 further comprises a second contact layer 15 arranged on a side of the reflection layer 11 facing away from the semiconductor layer stack 2. The second contact layer 15 comprises a conductive material, for example a metal material. The first and second contact layers 14, 15 ensure a homogeneous current spreading.

The first and second contact layers 14, 15 are electrically interconnected by a contact element 16, which is arranged in an opening 18 of the reflection layer 11. An electrically insulating layer 19 covers the second contact layer 15.

The first contact 13 further comprises a first contact pad 17 at the rear side 1B which is in electrical contact with the second contact layer 15. The first contact pad 17 comprises a conductive material, for example a metal material.

The second contact 20 comprises a plurality of contact portions 21, which penetrate the active zone 4. The number of contact portions 21 can be more than the two contact portions 21 shown in Figure 1. In particular, the contact portions 21 extend from the rear side 1B of the laser diode component 1 trough the active zone 4 to the second semiconductor region 5. The contact portions 21 are arranged in recesses 24 of the semiconductor layer stack 2, wherein the recesses 24 continue from the semiconductor layer stack 2 through the reflection layer 11 to the rear side 1B. Each contact portion 21 covers an end face 24A and side walls 24B of the respective recess 24. Especially, the contact portions 21 have shapes of truncated cones or pyramids.

The contact portions 21 and recesses 24 are regularly arranged in the semiconductor layer stack 2 and form a two-dimensional lattice, for example. The regularly arranged contact portions 21 enable a homogeneous current injection and thus an improved beam profile even if the emission aperture is enlarged, and thus a high-performance laser diode component 1 is realized.

The (average) lateral dimensions a' and/or spacings d' of the recesses 24 or contact portions 21 may be greater than the wavelength of the laser radiation. However, it is also possible for the recesses 24 or contact portions 21 to have the same lateral dimensions a' and/or spacings d' as the structured portions 10. A part of the contact portions 21 or recesses 24 may be arranged where nodes occur. Advantageously, this reduces absorption losses in the contact portions 21.

The penetrating contact portions 21 may comprise a reflective, electrically conductive material, for example a metal or metal compound including Ag or Au, for example.

Additionally, the penetrating contact portions 21 comprise a transparent, electrically conductive material, for example a TCO.

The contact portions 21 pass through the first and second contact layers 14, 15.

The laser diode component 1 comprises an insulating layer 25, which laterally surrounds the contact portions 21 in the recesses 24 and is arranged between the semiconductor layer stack 2 and the contact portions 21. The insulating layer 25 may prevent the contact portions 21 from causing leakage current along the sidewalls 24B of the recesses 24. The insulating layer 25 may comprise a transparent, electrically insulating material. Suitable materials for the insulating layer 25 are, for example, silicon oxides, for example SiO₂, or silicon nitrides.

By combining a suitable insulating material and a suitable reflective material, the optical modes can be effectively reflected at the sidewalls 24B.

Choosing transparent materials for the insulating layer 25 and the contact portions 21 allows the optical modes to be transmitted through the recesses 24.

A high transparency or reflectivity is especially advantageous if the lateral dimensions a' and/or spacings d' of the contact portions are greater than the wavelength of the laser radiation.

The lateral dimensions a' and materials of the contact portions 21 or recesses 24 are chosen not to degrade the electrical and optical functioning of the active zone **4.**

The second contact 20 further comprises connection portions 22, which mechanically and electrically interconnect the contact portions 21 at the rear side 1B. And the second contact 20 comprises a second contact pad 23 arranged at the rear side 1B of the laser diode component 1 which is in electrical contact with the connection portions 22. The second contact pad 23 comprises a conductive material, for example a metal material.

A further insulating layer 26 is arranged on a side of the contact portions 21 and connection portions 22 facing away from the semiconductor layer stack 2. The further insulating layer 26 provides an electrical isolation inter alia between the first contact pad 17 and the connection portion 22.

The laser diode component 1 is suitable as a high power laser diode having power outputs in the range of watts, for example between 1 W and more than 10 W. The laser diode component 1 may be operated in pulsed mode or continuous wave mode. The laser radiation emitted from the laser diode component 1 especially has a symmetric beam profile, for example a Gaussian beam profile.

In connection with Figure 2, another exemplary embodiment of a laser diode component 1 is described. Especially, the laser diode component 1 is a PCSEL.

The laser diode component 1 comprises a photonic crystal structure 8 which is a part of a semiconductor layer stack 2 of the laser diode component 1. Especially, the semiconductor layer stack 2 forms a base layer 9 of the photonic crystal structure 8. The semiconductor layer stack 2 comprises recesses 24 where contact portions 21 of a second contact 20 are arranged and which recesses 24 form structured portions 10 of the photonic crystal structure 8. In this exemplary embodiment, an overlap with the wave is higher than in the case of the exemplary embodiment explained in connection with Figure 1. This allows a reduced refractive index contrast while still achieving the desired overall effect.

The recesses 24 and contact portions 21 are arranged regularly in the semiconductor layer stack 2 and may form a two-dimensional lattice structure.

Preferably, the recesses 24 or contact portions 21 have spacings d' in the range of one wavelength of the laser radiation and thus are in the range of fractions of a micrometer. Moreover, the recesses 24 or contact portions 21 can have dimensions a' of up to about half the wavelength of the laser radiation. The recesses 24 and contact portions 21 may be pillars of rectangular, circular or other shapes. The contact portions 21 or recesses 24 may or may not be arranged where nodes occur.

The recesses 24 or contact portions 21 may have different dimensions and/or shapes and/or be arranged in different patterns or different multiple lattices of different periodicity. For example, there can be recesses of two different shapes on two different lattices.

The contact portions 21 are formed from a transparent electrically conductive material like TCO as mentioned in connection with the exemplary embodiment of Figure 1. Moreover, the contact portions 21 are laterally surrounded by an insulating layer 25 which may have the features discussed in connection with the exemplary embodiment of Figure 1.

The laser diode component 1 comprises a reflection layer 11 facing the rear side 1B which may be a part of the semiconductor stack 2 or the first semiconductor region 3 and may comprise sublayers formed of a semiconductor material and having different refractive indices. The reflection layer 11 can also be as in the exemplary embodiment of Figure 1, that is, composed of metal or metal and dielectric layers.

The laser diode component 1 comprises a first contact 13 including a contact layer 14, which electrically contacts the first semiconductor region 3, and a first contact pad 17 at a lateral side 1C of the laser diode component 1, which first contact pad 17 is in electrical contact with the contact layer 14.

An insulating layer 19 covers the contact layer 14 on a side facing the rear side 1B.

The second contact 20 comprises a large-area contact pad 23 at the rear side 1B which covers the insulating layer 19 and electrically interconnects the contact portions 21. The contact portions 21 pass through the contact layer 14 and the insulating layer 19.

In addition, the laser diode component 1 may have any of the features, characteristics and advantages mentioned in connection with the further exemplary embodiment.

The invention is not limited to these embodiments by the description based on the embodiments. Rather, the invention includes any new feature and any combination of features, which includes in particular any combination of features in the patent claims, even if this feature or this combination itself is not explicitly explained in the patent claims or embodiments.

This patent application claims the priority of German patent application 102022102877.1.

### References

1 laser diode component
1A emission side
1B rear side
1C lateral side
1D radiation outcoupling surface
2 semiconductor layer stack
2A first main surface
2B second main surface
3 first semiconductor region
4 active zone
5 second semiconductor region
6 first cladding layer
7 second cladding layer
8 photonic crystal structure
9 base layer
10 structured portions
11 reflection layer
11A, 11B sublayer
12 contacts
13 first contact
14 first contact layer
15 second contact layer
16 contact element
17 first contact pad
18 opening
19 insulating layer
20 second contact
21 contact portion
22 connection portion
23 second contact pad
24 recess
24A end face
24B side wall
25 insulating layer
26 insulating layer
a, a' lateral dimension
b vertical dimension
d, d' spacing
V vertical direction

## Claims

1. A laser diode component (1) comprising
- a semiconductor layer stack (2) comprising an active zone (4) for emitting laser radiation,
- a photonic crystal structure (8) comprising a plurality of structured portions (10),
- contacts (12) for electrically contacting the laser diode component (1), one contact (20) comprising a plurality of contact portions (21), which are arranged in recesses (24) of the semiconductor layer stack (2) and penetrate the active zone (4),
**characterized in that** the penetrating contact portions (21) comprise a transparent, electrically conductive material.

2. The laser diode component (1) according to any of the preceding claims, wherein the penetrating contact portions (21) comprise a reflective, electrically conductive material.

3. The laser diode component (1) according to any of the preceding claims, wherein the laser diode component (1) comprises an insulating layer (25) laterally surrounding the contact portions (21) in the recesses (24).

4. The laser diode component (1) according to the preceding claim, wherein the insulating layer (25) comprises a transparent, electrically insulating material.

5. The laser diode component (1) according to any of the preceding claims, wherein the photonic crystal structure (8) is arranged outside the active zone (4).

6. The laser diode component (1) according to the preceding claim, wherein the recesses (24) or contact portions (21) have greater lateral dimensions (a') and/or spacings (d') than the structured portions (10).

7. The laser diode component (1) according to any of the preceding claims, wherein the photonic crystal structure (8) is arranged on a side of the active zone (4) facing an emission side (1A) of the laser diode component (1).

8. The laser diode component (1) according to any of claims 1 to 4, wherein the recesses (24) form structured portions (10) of the photonic crystal structure (8).

9. The laser diode component (1) according to any of the preceding claims, wherein a radiation outcoupling surface (1D) arranged at an emission side (1A) of the laser diode component (1), where an essential part of the laser radiation is emitted, is free of contacts (12).

10. The laser diode component (1) according to any of the preceding claims, wherein the contacts (12) comprise a first contact (13) for electrically contacting a first semiconductor region (3) of the semiconductor layer stack (2) and further comprise a second contact (20) for electrically contacting a second semiconductor region (5) of the semiconductor layer stack (2), and wherein the contact portions (21) are parts of the second contact (20).

11. The laser diode component (1) according to any of the preceding claims, wherein the laser diode component (1) comprises a reflection layer (11) facing a rear side (1B) of the laser diode component (1).

12. The laser diode component (1) according to any of the preceding claims, wherein the photonic crystal structure (8) comprises a base layer (9), and the structured portions (10) are voids in the base layer (9).

13. The laser diode component (1) according to any of the preceding claims, wherein the structured portions (10) have spacings (d) in the range of one wavelength of the laser radiation.

14. The laser diode component (1) according to the preceding claim, wherein the structured portions (10) have dimensions (a, b) of up to about half the wavelength of the laser radiation.

## Patentansprüche

1. Laserdiodenbauteil (1) umfassend
- einen Halbleiterschichtstapel (2) mit einer aktiven Zone (4) zum Emittieren von Laserstrahlung,
- eine photonische Kristallstruktur (8) mit mehreren strukturierten Bereichen (10),
- Kontakte (12) zum elektrischen Kontaktieren des Laserdiodenbauteils (1), wobei ein Kontakt (20) mehrere Kontaktbereiche (21) umfasst, die in Ausnehmungen (24) des Halbleiterschichtstapels (2) angeordnet sind und die aktive Zone (4) durchdringen,
**dadurch gekennzeichnet, dass** die durchdringenden Kontaktbereiche (21) ein transparentes, elektrisch leitfähiges Material umfassen.

2. Laserdiodenbauteil (1) nach einem der vorstehenden Ansprüche, wobei die durchdringenden Kontaktbereiche (21) ein reflektierendes, elektrisch leitfähiges Material umfassen.

3. Laserdiodenbauteil (1) nach einem der vorstehenden Ansprüche, wobei das Laserdiodenbauteil (1) eine Isolierschicht (25) umfasst, die die Kontaktbereiche (21) in den Aussparungen (24) seitlich umgibt.

4. Laserdiodenbauteil (1) nach dem vorstehenden Anspruch, wobei die Isolierschicht (25) ein transparentes, elektrisch isolierendes Material umfasst.

5. Laserdiodenbauteil (1) nach einem der vorstehenden Ansprüche, wobei die photonische Kristallstruktur (8) außerhalb der aktiven Zone (4) angeordnet ist.

6. Laserdiodenbauteil (1) nach dem vorstehenden Anspruch, wobei die Aussparungen (24) oder Kontaktbereiche (21) größere laterale Abmessungen (a') und/oder Abstände (d') aufweisen als die strukturierten Bereiche (10).

7. Laserdiodenbauteil (1) nach einem der vorstehenden Ansprüche, wobei die photonische Kristallstruktur (8) auf einer Seite der aktiven Zone (4) angeordnet ist, die einer Emissionsseite (1A) des Laserdiodenbauteils (1) zugewandt ist.

8. Laserdiodenbauteil (1) nach einem der Ansprüche 1 bis 4, wobei die Aussparungen (24) strukturierte Bereiche (10) der photonischen Kristallstruktur (8) bilden.

9. Laserdiodenbauteil (1) nach einem der vorstehenden Ansprüche, wobei eine an einer Emissionsseite (1A) des Laserdiodenbauteils (1) angeordnete Strahlaustrittsfläche (1D), an der ein wesentlicher Teil der Laserstrahlung emittiert wird, frei von Kontakten (12) ist.

10. Laserdiodenbauteil (1) nach einem der vorstehenden Ansprüche, wobei die Kontakte (12) einen ersten Kontakt (13) zum elektrischen Kontaktieren eines ersten Halbleiterbereichs (3) des Halbleiterschichtstapels (2) und ferner einen zweiten Kontakt (20) zum elektrischen Kontaktieren eines zweiten Halbleiterbereichs (5) des Halbleiterschichtstapels (2) umfassen, und wobei die Kontaktbereiche (21) Teile des zweiten Kontakts (20) sind.

11. Laserdiodenbauteil (1) nach einem der vorstehenden Ansprüche, wobei das Laserdiodenbauteil (1) eine Reflexionsschicht (11) umfasst, die einer Rückseite (1B) des Laserdiodenbauteils (1) zugewandt ist.

12. Laserdiodenbauteil (1) nach einem der vorstehenden Ansprüche, wobei die photonische Kristallstruktur (8) eine Basisschicht (9) umfasst und die strukturierten Bereiche (10) Hohlräume in der Basisschicht (9) sind.

13. Laserdiodenbauteil (1) nach einem der vorstehenden Ansprüche, wobei die strukturierten Bereiche (10) Abstände (d) im Bereich einer Wellenlänge der Laserstrahlung aufweisen.

14. Laserdiodenbauteil (1) nach dem vorstehenden Anspruch, wobei die strukturierten Bereiche (10) Abmessungen (a, b) von bis zu etwa der Hälfte der Wellenlänge der Laserstrahlung aufweisen.

## Revendications

1. Composant de diode laser (1) comprenant
- un empilement de couches semi-conductrices (2) comprenant une zone active (4) pour émettre un rayonnement laser,
- une structure à cristal photonique (8) comprenant une pluralité de parties structurées (10),
- des contacts (12) destinés à établir un contact électrique avec le composant de diode laser (1), un contact (20) comprenant une pluralité de parties de contact (21) qui sont disposées dans des évidements (24) de l'empilement de couches semi-conductrices (2) et pénètrent la zone active (4),
**caractérisé en ce que** les parties de contact pénétrantes (21) comprennent un matériau transparent, électriquement conducteur.

2. Composant de diode laser (1) selon l'une quelconque des revendications précédentes, dans lequel les parties de contact pénétrantes (21) comprennent un matériau réfléchissant et électriquement conducteur.

3. Composant de diode laser (1) selon l'une quelconque des revendications précédentes, dans lequel le composant de diode laser (1) comprend une couche isolante (25) entourant latéralement les parties de contact (21) dans les évidements (24).

4. Composant de diode laser (1) selon la revendication précédente, dans lequel la couche isolante (25) comprend un matériau transparent et électriquement isolant.

5. Composant de diode laser (1) selon l'une quelconque des revendications précédentes, dans lequel la structure à cristal photonique (8) est disposée à l'extérieur de la zone active (4).

6. Composant à diode laser (1) selon la revendication précédente, dans lequel les évidements (24) ou les parties de contact (21) ont des dimensions latérales (a') et/ou des distances (d') supérieures à ceux des parties structurées (10).

7. Composant de diode laser (1) selon l'une quelconque des revendications précédentes, dans lequel la structure à cristal photonique (8) est disposée sur un côté de la zone active (4) faisant face à un côté d'émission (1A) du composant de diode laser (1).

8. Composant de diode laser (1) selon l'une quelconque des revendications 1 à 4, dans lequel les évidements (24) forment des parties structurées (10) de la structure à cristal photonique (8).

9. Composant de diode laser (1) selon l'une quelconque des revendications précédentes, dans lequel une surface de découplage de rayonnement (1D) disposée à un côté d'émission (1A) du composant de diode laser (1), où une partie essentielle du rayonnement laser est émise, est exempte de contacts (12).

10. Composant de diode laser (1) selon l'une quelconque des revendications précédentes, dans lequel les contacts (12) comprennent un premier contact (13) pour mettre en contact électrique une première région semi-conductrice (3) de l'empilement de couches semi-conductrices (2) et comprennent en outre un deuxième contact (20) pour mettre en contact électrique une deuxième région semi-conductrice (5) de l'empilement de couches semi-conductrices (2), et dans lequel les parties de contact (21) font partie du deuxième contact (20).

11. Composant de diode laser (1) selon l'une quelconque des revendications précédentes, dans lequel le composant de diode laser (1) comprend une couche réfléchissante (11) faisant face à une face arrière (1B) du composant de diode laser (1).

12. Composant à diode laser (1) selon l'une quelconque des revendications précédentes, dans lequel la structure à cristal photonique (8) comprend une couche de base (9) et les parties structurées (10) sont des vides dans la couche de base (9).

13. Composant de diode laser (1) selon l'une quelconque des revendications précédentes, dans lequel les parties structurées (10) ont des distances (d) comprises dans la plage d'une longueur d'onde du rayonnement laser.

14. Composant de diode laser (1) selon la revendication précédente, dans lequel les parties structurées (10) ont des dimensions (a, b) allant jusqu'à environ la moitié de la longueur d'onde du rayonnement laser.
